# FASCICULE DE BREVET EUROPEEN

(11) **EP 1 005 161 B1**
(45) Date de publication et mention de la délivrance du brevet: **22.02.2006**
(21) Numéro de dépôt: 99410170.7
(22) Date de dépôt: 25.11.1999
(51) Int. Cl.: H03K 17/687

(54) **Circuit de commande d'un interrupteur a composants semiconducteurs fonctionnant en alternatif**
Steuerungsschaltung für einen Halbleiterschalter im Wechselbetrieb
Control circuit for a semiconductor switch for AC voltages

(30) Priorité: 27.11.1998 FR 9815150
(43) Date de publication de la demande: 31.05.2000
(73) Titulaire: STMicroelectronics S.A., 92120 Montrouge (FR)
(72) Inventeur: Gonthier, Laurent, 37000 Tours (FR)
(74) Mandataire: de Beaumont, Michel

(56) Documents cités:
- EP-A- 0 822 645
- DE-A- 2 914 277
- US-A- 4 737 667
- US-A- 5 321 597
- US-A- 5 550 463
- US-A- 5 796 599
- PATENT ABSTRACTS OF JAPAN vol. 14, no. 89 (E-891), 19 février 1990 (1990-02-19) & JP 01 298811 A (NEC CORP.), 1 décembre 1989 (1989-12-01)
- PATENT ABSTRACTS OF JAPAN vol. 7, no. 132 (E-180), 9 juin 1983 (1983-06-09) & JP 58 048529 A (ORIGIN DENKI), 22 mars 1983 (1983-03-22)
- PATENT ABSTRACTS OF JAPAN vol. 16, no. 405 (M-1301), 26 août 1992 (1992-08-26) & JP 04 135938 A (MITSUBISHI ELECTRIC CORP.)

## Description

La présente invention concerne un interrupteur, pour une charge destinée à être alimentée par une tension alternative, par exemple, le secteur (par exemple, 240V/50Hz ou 110V/60Hz). L'invention concerne, plus particulièrement, la réalisation d'un circuit de commande d'une charge à partir d'un signal de commande basse tension. Il s'agit, par exemple, d'un interrupteur statique, d'un variateur de puissance, d'un hacheur, etc.

La commande d'une charge alternative à partir d'un réseau de tension alternative implique l'utilisation d'un interrupteur qui soit, à la fois, bidirectionnel en courant et en tension, c'est-à-dire, un interrupteur dit quatre quadrants.

La présente invention s'applique plus particulièrement à un tel interrupteur, réalisé au moyen de deux commutateurs distincts pour les deux sens du courant, à la différence d'un triac qui est bidirectionnel. Dans un montage à deux commutateurs unidirectionnels, ces deux commutateurs peuvent être ouvrables (blocables) pour respecter une contrainte d'ouverture sous un courant non nul.

Un problème qui se pose dans tout montage utilisant deux commutateurs à semiconducteur pour réaliser un interrupteur quatre quadrants, est le fait qu'un des deux commutateurs doit être commandé à partir d'un potentiel flottant.

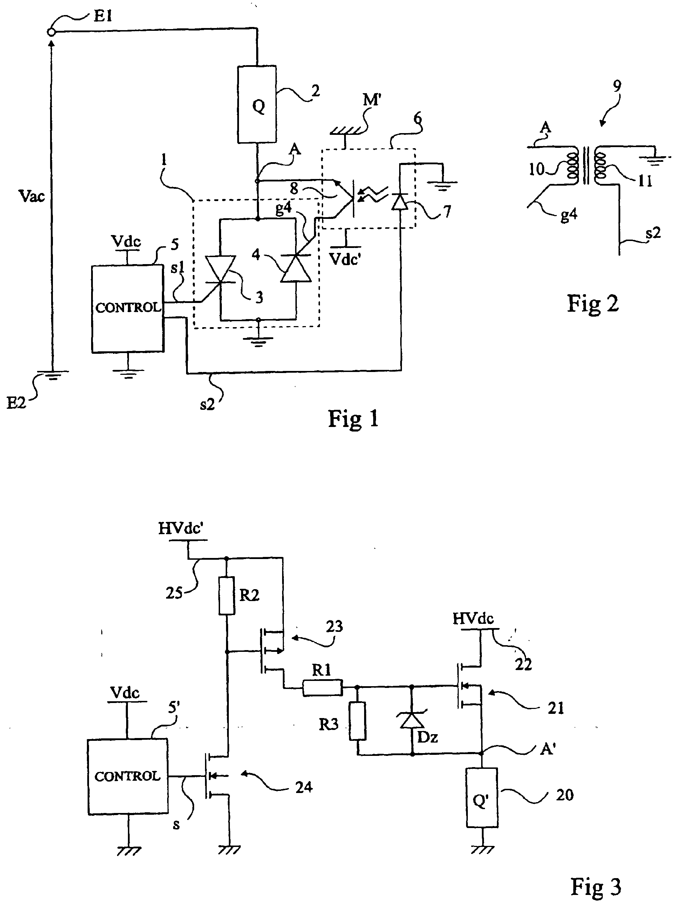

Ce problème est illustré par la figure 1 qui représente un exemple classique d'un interrupteur quatre quadrants 1 en série avec une charge (Q) 2 entre deux bornes E1, E2 d'application d'une tension alternative Vac. Dans l'exemple de la figure 1, l'interrupteur 1 est formé de deux thyristors 3, 4 montés en antiparallèle entre une borne A de la charge 2 et la borne E2, par exemple, le neutre de l'alimentation alternative constituant la masse du montage.

L'emploi de thyristors implique une application dans laquelle il n'est pas nécessaire d'ouvrir l'interrupteur 1 sous un courant non nul, les thyristors se bloquant par disparition du courant qui les traverse. Pour une possibilité d'ouverture sous courant non nul, on utilise alors des composants blocables, par exemple, des transistors MOS comme on le verra par la suite.

Les thyristors 3 et 4 sont commandés à partir d'un bloc de commande 5 (CONTROL) alimenté, généralement, par une basse tension continue vdc provenant d'une alimentation auxiliaire. Le bloc 5 délivre, dans les montages classiques, deux signaux de commande s1, s2 destinés, respectivement, aux thyristors 3 et 4.

La commande du thyristor 3 par le signal s1 ne pose pas de problème de référence particulier dans la mesure où l'anode de ce thyristor est connectée à la, même masse que celle du bloc de commande 5. Par contre, la commande du thyristor 4 doit s'effectuer par l'intermédiaire d'un bloc 6 d'isolement, dans la mesure où la cathode du thyristor est connectée au noeud A.

Dans l'exemple de la figure 1, le bloc d'isolement 6 est un optocoupleur dont la diode émettrice 7 reçoit, sur son anode, le signal s2 issu du bloc 5 et dont la cathode est reliée à la masse (E2) commune au bloc 5 et à la charge alternative 2 (par l'intermédiaire de l'interrupteur 1) . Le phototransistor 8 de l'optocoupleur 6 est relié, par son collecteur, à la gâchette g4 du thyristor 4 et, par son émetteur, au noeud A.

La polarisation du phototransistor 8 nécessite une alimentation auxiliaire continue Vdc', différente de l'alimentation Vdc du bloc 5. En effet, l'émetteur du phototransistor 8 doit être connecté à un potentiel de référence M' qui est forcément différent de la masse (E2) du reste du montage, donc du potentiel de référence de la tension vdc. Le bloc 6 est donc généralement alimenté par une tension Vdc' référencée au potentiel M'.

Le fonctionnement d'un interrupteur bidirectionnel 1 tel que représenté à la figure 1 est parfaitement connu. Le bloc 5 de commande organise les conductions respectives des thyristors 3 et 4 selon l'alternance de l'alimentation alternative Vac et selon une consigne de commande qui dépend de l'application.

Un inconvénient d'un circuit tel que celui représenté à la figure 1 est que le recours à un optocoupleur nécessite deux alimentations auxiliaires isolées galvaniquement Vdc et Vdc', ayant des références différentes.

En remplacement de l'optocoupleur 6 de la figure 1, on peut également utiliser un transformateur d'impulsions 9 comme l'illustre la figure 2. Par souci de simplification, la figure 2 ne reprend pas tous les éléments du montage de la figure 1. Seul le transformateur 9 y est représenté, le reste du montage étant similaire. Un premier enroulement 10 du transformateur 9 est connecté entre la borne A et la gâchette g4 du thyristor 4 (figure 1), c'est-à-dire de façon similaire à la connexion du phototransistor 8. Un deuxième enroulement 11 du transformateur 9 est connecté entre la masse (E2) du montage et la borne délivrant le signal de commande s2. un inconvénient de la solution illustrée partiellement par la figure 2 est précisément le recours à un transformateur d'impulsions. De plus, on utilise généralement un transformateur d'impulsions fonctionnant à une fréquence élevée par rapport à la fréquence de la tension Vac dans un souci de réduction d'encombrement. Le bloc de commande 5 du montage doit alors fournir des impulsions de commande à haute fréquence. En outre, une solution à transformateur telle qu'illustrée par la figure 2 exclut l'emploi de transistors pour constituer l'interrupteur. En effet, pour utiliser des transistors (par exemple, des transistors MOS de puissance) à la place des thyristors, le signal de commande ne peut pas être alternatif mais doit être continu, ce qui impose alors de redresser le signal du transformateur et complique le schéma.

Un autre inconvénient commun aux deux exemples classiques ci-dessus, qu'il s'agisse d'un montage à optocoupleur ou à transformateur d'impulsions, est que ces deux montages ne sont pas intégrables.

Le document US-A-5 796 599 décrit un circuit de commande d'un interrupteur bidirectionnel formé de deux commutateurs unidirectionnels associés en antiparallèle, du type auquel se rapporte la présente invention. Ce document prévoit de commander les commutateurs à partir de deux tensions continues qu'il génère aux bornes de deux condensateurs respectivement associés à chaque commutateur. Outre le fait qu'il nécessite deux tensions continues distinctes pour commander les thyristors constitutifs des commutateurs unidirectionnels, ces tensions sont référencées à des potentiels différents correspondant aux bornes de puissance respectives de l'interrupteur. Par conséquent, l'absence de référence commune rend obligatoire le recours à un moyen d'isolement (optocoupleur ou transformateur) .

La présente invention vise à proposer une nouvelle solution pour commander un interrupteur bidirectionnel en courant et en tension, réalisé sous la forme de deux composants semiconducteurs distincts. L'invention vise, en particulier, à proposer une solution qui soit compatible avec l'utilisation de deux commutateurs semiconducteurs unidirectionnels, montés en anti-parallèle comme dans les montages classiques.

L'invention vise également à éviter le recours à deux alimentations auxiliaires pour la commande de l'interrupteur, sans nécessiter le recours à un transformateur haute fréquence.

La présente invention vise, en outre, à proposer un circuit de commande qui soit intégrable.

La présente invention s'inspire des montages classiques, dits décaleurs de niveau (level shifter), qui sont généralement utilisés pour la commande de composants MOS à potentiel flottant, unidirectionnels en tension. Il s'agit donc de décaleurs de tension utilisés pour des alimentations continues. Un montage décaleur de niveau est conçu pour commander un transistor MOS à canal N, monté du côté positif de l'alimentation, c'est-à-dire où la charge est connectée entre la source du transistor MOS et la référence du bloc de commande. Le drain du transistor MOS est alors connecté côté potentiel positif.

La figure 3 représente le schéma classique d'un montage décaleur de niveau pour alimenter une charge 20 (Q') à partir d'une haute tension continue HVdc, la charge 20 étant montée en série avec un interrupteur 21 unidirectionnel en tension (généralement, un transistor MOS à canal N), entre une borne 22 d'application de la tension HVdc et la masse du montage.

Le circuit décaleur de niveau comprend essentiellement un transistor MOS à canal P 23 dont la source est connectée à une borne 25 d'application d'une tension HVdc', supérieure à la tension Hvdc, mais ayant la même référence. Le drain du transistor 23 est connecté, par l'intermédiaire d'une résistance R1, à la grille du transistor 21. Le transistor 23 est commandé au moyen d'un transistor MOS à canal N 24, connecté en série avec une résistance. R2 entre la borne 25 et la masse. Le point milieu de cette association en série est connecté à la grille du transistor 23. La grille du transistor 24 reçoit un signal de commande s d'un bloc 5' de commande (CONTROL) alimenté par une basse tension Vdc (généralement obtenue à partir de la tension HVdc). Une diode Zener DZ relie la grille du transistor 21 au noeud A' d'interconnexion du transistor 21 et de la charge 20. Une résistance R3 est connectée en parallèle sur la diode DZ.

Le fonctionnement d'un montage décaleur de niveau tel qu'illustré par la figure 3 est le suivant.

L'application d'une tension positive sur la grille du transistor 24 par le signal s rend celui-ci conducteur et abaisse le potentiel de la grille du transistor 23 sensiblement à la masse (en négligeant la résistance drain-source du transistor 24 à l'état passant). Il en découle que le transistor 23 devient passant. La tension HVdc' est alors appliquée sur le drain du transistor 23 (en négligeant la résistance drain-source à l'état passant du transistor 23). Les résistances R1 et R3 constituent un pont diviseur dont le point milieu est connecté à la grille du transistor 21. Par exemple, les résistances R1 et R3 ont la même valeur de sorte que la tension maximale appliquée à la grille du transistor 21 correspond à la différence entre les tensions HVdc' et HVdc, divisée par deux.

Le rôle de la diode Zener DZ est de fixer la tension grille-source du transistor 21 à la tension seuil de cette diode Zener quand le transistor 23 est rendu passant par le bloc de commande 5' (par l'intermédiaire de la mise en conduction du transistor 24).

Une fois que le transistor 21 est rendu passant, la tension aux bornes de la charge 20 est égale à HVdc (en négligeant la chute de tension dans le transistor 21 à l'état passant). Il en découle que la différence de potentiels entre la source du transistor 23 et la source (A') du transistor 21 devient égale à la différence entre les tensions HVdc' et HVdc. La tension HVdc' est choisie suffisamment élevée par rapport à la tension HVdc (par exemple, HVdc' = HVdc + 20 volts) pour que la grille du transistor 21 soit maintenue à un potentiel suffisamment élevé par rapport à sa source A' pour qu'il reste passant.

L'ouverture du transistor 21 est provoquée par l'ouverture du transistor 23 (donc, par l'ouverture du transistor 24). La résistance R3 sert alors à décharger la grille du transistor 21 pour le bloquer.

On notera que, même pour une application au continu, un décaleur de niveau souffre du recours obligatoire à une alimentation auxiliaire supplémentaire pour générer la tension HVdc' .

On pourrait toutefois penser transposer un montage décaleur de niveau tel qu'utilisé pour une charge continue à un montage alimenté par une tension alternative.

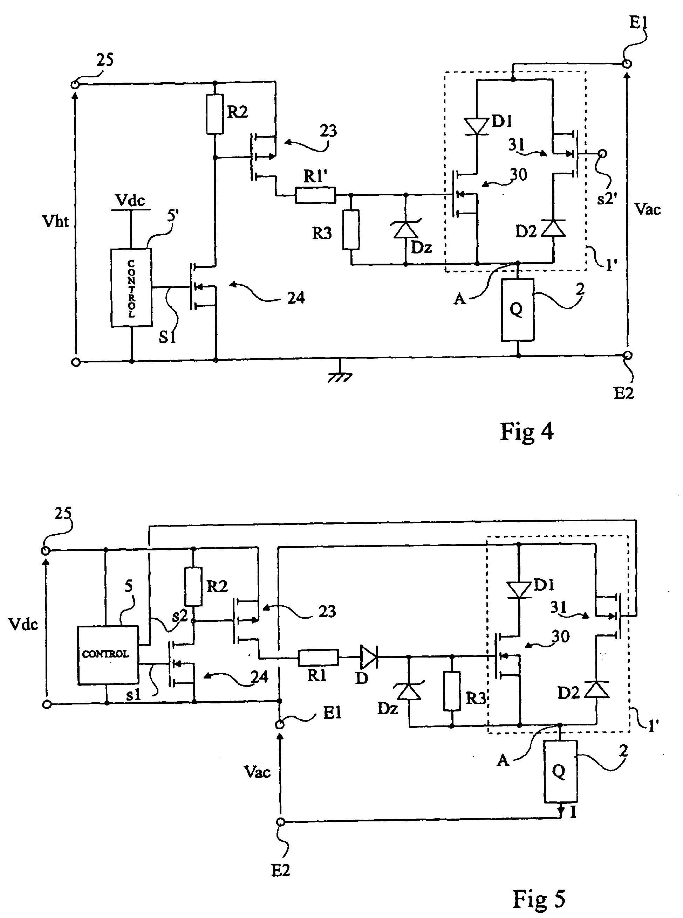

La figure 4 illustre une telle transposition.

Comme la charge 2 doit être alimentée par une tension alternative Vac, le transistor MOS 21 (figure 3) a été remplacé par un montage 1' de deux commutateurs unidirectionnels montés en antiparallèle. Dans l'exemple de la figure 4, il s'agit de deux transistors MOS à canal N 30, 31 respectivement associés en série à des diodes D1 et D2 en inverse l'une par rapport à l'autre, les deux associations en série résultantes étant montées en parallèle entre la borne E1 (la phase de l'alimentation Vac) et le noeud A d'interconnexion de la charge 2 avec l'interrupteur 1'. Plus précisément, le transistor 30 est connecté en série avec une première diode D1 dont l'anode est connectée à la borne E1 et dont la cathode est reliée au drain du transistor 30, la source du transistor 30 étant connectée au noeud A. Le transistor 31 est associé en série avec une deuxième diode D2, dont l'anode est connectée au noeud A et dont la cathode est reliée au drain du transistor 31 dont la source est connectée à la borne E1.

Les autres constituants du montage sont transposés d'un décaleur de niveau tel qu'illustré par la figure 3. Ainsi, une diode Zener DZ est connectée entre la grille du transistor 30 et le noeud A. Une résistance R3 est connectée en parallèle sur la diode DZ. Un transistor MOS à canal N 24, commandé par un bloc 5' alimenté par une tension continue Vdc, sert à commander un transistor MOS à canal P 23, dont la source est connectée à la borne 25 d'application de la tension Vht et dont le drain est connecté, par l'intermédiaire d'une résistance R1', à la grille du transistor 30. Une résistance R2 est connectée entre la source et la grille du transistor 23, cette dernière étant connectée au drain du transistor 24.

Le fonctionnement du montage de la figure 4 se déduit du fonctionnement illustré en relation avec la figure 3.

La transposition, à une charge alternative, d'un montage décaleur de niveau classique présente des inconvénients qui rendent une telle solution difficilement applicable en pratique.

Un premier inconvénient est que, pour permettre la commande du transistor 30 lors de la mise en conduction du transistor 23, la tension continue Vht doit être une haute tension dont la valeur est supérieure à l'amplitude maximale de la tension alternative Vac, de façon à garantir une tension grille-source positive pour le transistor 30.

Un deuxième inconvénient est que, pendant que le transistor 23 est passant, la résistance R1' voit, à ses bornes, une haute tension qui peut atteindre, au minimum d'une alternance négative de la tension Vac, l'amplitude de cette tension majorée de la tension Vht. Ainsi, pour une alimentation alternative du secteur sous 240 volts, la résistance R1' voit à ses bornes une tension qui excède 500 volts. Il en découle une forte dissipation dans cette résistance R1' qui constitue un inconvénient majeur du montage de la figure 4. On notera en effet que la tension entre la borne 25 et le noeud A est, lorsque le transistor 23 est passant, essentiellement aux bornes de la résistance R1', la tension aux bornes de la résistance R3 restant faible en étant limitée par la diode Zener DZ.

Un autre inconvénient du montage de la figure 4 est qu'il ne permet pas la génération d'un signal s2' de commande du transistor MOS à canal P 31, qui n'est pas référencé à la masse comme c'est le cas pour le signal de commande s1 du transistor 24. En effet, le signal s2' doit être référencé au potentiel de la borne E1, donc à la phase de l'alimentation alternative, alors que le bloc 5' est alimenté par la tension Vdc référencée à la masse (E2) du montage.

Tous les inconvénients ci-dessus conduisent à ce que la transposition d'un montage décaleur de niveau s'appliquant à une alimentation continue est difficilement utilisable en pratique pour une alimentation alternative .

La présente invention vise, plus particulièrement, à proposer une nouvelle solution qui pallie aux inconvénients ci-dessus.

En particulier, l'invention vise à proposer une solution qui, en s'inspirant d'un montage décaleur de niveau du type de ceux utilisés pour des alimentations continues, puisse être utilisée pour l'alimentation d'une charge alternative.

Pour atteindre ces objets, la présente invention prévoit un circuit de commande d'un interrupteur bidirectionnel connecté en série avec une charge devant être alimentée par une tension alternative, ledit interrupteur bidirectionnel étant constitué de deux commutateurs unidirectionnels associés en antiparallèle et commandés par un bloc à partir d'une basse tension continue, caractérisé en ce que ladite tension continue est référencée sur une première borne d'application de la tension alternative à laquelle est relié l'interrupteur bidirectionnel.

Selon un mode de réalisation de la présente invention, les commutateurs unidirectionnels sont commandés par des signaux référencés au potentiel de référence de la tension continue.

Selon un mode de réalisation de la présente invention, les commutateurs unidirectionnels sont commandés par un même signal.

Selon un mode de réalisation de la présente invention, le circuit comporte des moyens pour rendre la valeur de ladite tension continue indépendante de la valeur de la tension alternative.

Selon un mode de réalisation de la présente invention, le circuit comporte, en série entre une borne positive de l'alimentation continue et une borne de commande d'un premier commutateur unidirectionnel, destiné à conduire quand le courant dans la charge, connectée entre ladite première borne et une deuxième borne d'application de la tension alternative, est positif, un troisième commutateur, une première résistance et une première diode.

Selon un mode de réalisation de la présente invention, le troisième commutateur a une borne de commande connectée au point milieu d'une association en série d'une deuxième résistance et d'un quatrième commutateur, entre les deux bornes d'application de la basse tension continue.

Selon un mode de réalisation de la présente invention, les troisième et quatrième commutateurs sont des transistors MOS.

Selon un mode de réalisation de la présente invention, les commutateurs unidirectionnels sont des transistors MOS associés, chacun, à une diode montée en série.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
les figures 1 à 4 décrites précédemment sont destinées à exposer l'état de la technique et le problème posé ;
la figure 5 représente un premier mode de réalisation d'un circuit de commande d'un interrupteur bidirectionnel constitué de deux commutateurs semiconducteurs unidirectionnels commandés en tension selon la présente invention ; et
la figure 6 représente un deuxième mode de réalisation d'un circuit de commande d'un interrupteur bidirectionnel constitué de deux commutateurs semiconducteurs unidirectionnels commandés en courant selon la présente invention.

Pour des raisons de clarté, les mêmes éléments ont été désignés par les mêmes références aux différentes figures. Par souci de simplification, seuls les éléments du circuit de commande qui sont nécessaires à la compréhension de l'invention ont été représentés aux figures et seront décrits par la suite. En particulier, la constitution des blocs générant les signaux de commande à partir d'une alimentation continue basse tension n'a pas été détaillée, que ce soit pour les circuits de l'art antérieur décrits précédemment ou pour les circuits de l'invention qui seront décrits par la suite. La constitution de ces blocs est à la portée de l'homme du métier et ne fait pas l'objet de la présente invention. Cette constitution dépend, en particulier, de la charge devant être commandée et de l'application (par exemple, variateur, hacheur, commutateur statique, etc.) . De même, la réalisation et l'adaptation d'une alimentation auxiliaire en fonction de l'application sont à la portée de l'homme du métier.

Par convention et sauf précision contraire, toutes les tensions sont, dans la présente description, considérées comme étant référencées à la masse ou au neutre de l'alimentation alternative.

La figure 5 représente un premier mode de réalisation d'un circuit de commande selon la présente invention. Ce mode de réalisation est, plus particulièrement, destiné à la commande d'un interrupteur bidirectionnel 1' réalisé au moyen de deux transistors MOS 30, 31 à canal N, associés dans un montage en antiparallèle au moyen de deux diodes D1 et D2, tel que celui décrit précédemment en relation avec la figure 4. Le commutateur 1' est, comme dans le cas de la figure 4, connecté entre une borne E1 et le noeud A de l'association en série du commutateur 1' avec une charge 2 (Q) devant être alimentée par une tension alternative Vac. L'interrupteur bidirectionnel 1' est destiné à être commandé par un bloc 5 (CONTROL) alimenté par une basse tension continue Vdc.

Une caractéristique de la présente invention est d'associer, en série, les tensions d'alimentation continue Vdc et alternative Vac. Ainsi, selon la présente invention, la tension continue Vdc est référencée au potentiel de la borne E1, c'est-à-dire en pratique à la phase de l'alimentation alternative Vac. Il en découle que seule la borne de la charge 2, opposée au noeud A, est connectée au neutre E2 de l'alimentation alternative.

Une autre caractéristique de la présente invention est que la valeur de la basse tension de commande (par exemple, 5, 12, 24 ou 48 volts) fournie par l'alimentation auxiliaire est indépendante de la valeur de la tension alternative d'alimentation de la charge (par exemple, 240 volts ou 110 volts).

Le bloc de commande 5 est alimenté entre une borne positive 25 d'application de la tension Vdc et la borne E1. Ce bloc 5 délivre, par exemple, deux signaux de commande s1, s2. Le signal s1 est appliqué sur la grille d'un transistor MOS à canal N 24 dont la source est connectée à la borne E1 et dont le drain est connecté, par l'intermédiaire d'une résistance R2, à la borne 25. Le point milieu de l'association en série de la résistance R2 avec le transistor 24 est connecté à la grille d'un transistor MOS à canal P 23 dont la source est connectée à la borne 25. Le drain du transistor 23 est relié, par l'intermédiaire d'une résistance R1 en série avec une diode D, à la grille du transistor MOS à canal N 30 de l'interrupteur 1'. Une diode Zener DZ et une résistance R3 sont connectées, en parallèle, entre la grille et la source du transistor 30.

Le rôle de la diode D est de protéger l'alimentation continue Vdc contre une tension inverse. En effet, en l'absence de diode D, un courant pourrait circuler depuis l'alimentation alternative jusqu'au transistor 23. Le cas échéant, la diode D peut être supprimée si le transistor 23 a une tenue en tension bidirectionnelle suffisante.

En outre, grâce à la diode D, la (basse) tension de commande est décorrélée de la (haute) tension d'alimentation de la charge.

Le rôle de la diode DZ est, comme précédemment, de limiter la tension grille-source du transistor 30 à une tension inférieure à sa tension de claquage. Comme précédemment, la résistance R3 sert au blocage du transistor 30 en autorisant la décharge de sa grille.

Selon l'invention, le transistor 31 peut désormais être commandé par un signal s2 référencé au même potentiel que le signal s1 de commande du transistor 24, c'est-à-dire au moyen du même bloc de commande 5, sans qu'il soit nécessaire de recourir à un composant d'isolement comme dans les montages classiques des figures 1 et 2.

Pour qu'une commande en fermeture du commutateur 30 soit effective, il faut que la tension entre les bornes 25 et A soit positive (suffisante pour que le transistor 30 soit rendu conducteur quand le transistor 23 est passant) et que la tension entre les bornes E1 et A soit également positive pour que la diode D1 soit polarisée en direct.

Pour qu'une commande en fermeture du commutateur 31 soit effective, il faut que la tension entre les bornes s2 et E1 soit positive (suffisante pour que le transistor 31 soit rendu conducteur), ce qui est possible grâce à la tension Vdc référencée à la borne E1, et que la tension entre les bornes A et E1 soit également positive pour que la diode D2 soit polarisée en direct.

Supposons tout d'abord que les transistors 30 et 31 aient des comnandes différentes, c'est-à-dire que les signaux s1 et s2 ont des allures différentes.

Supposons qu'initialement, les deux commutateurs 30 et 31 sont ouverts de sorte que la charge n'est pas alimentée. Par conséquent, la tension entre les points A et E2 est nulle. Le respect des conditions indiquées ci-dessus conduit, pour que le commutateur 30 puisse être fermé, à des tensions positives entre les bornes 25 et E2 et entre les bornes E1 et E2, et, pour que le commutateur 31 puisse être fermé, à des tensions entre les bornes E1 et E2 et entre les bornes 25 et E1, respectivement négative et positive. On notera que la condition que la tension entre les bornes 25 et E1 soit positive est toujours respectée.

Une fois que la charge est alimentée, c'est-à-dire quand un des deux commutateurs 30 et 31 est passant, la tension entre les bornes A et E1 est sensiblement nulle (en négligeant les chutes de tension série dans la diode et le transistor qui conduisent). La tension Vdc entre les bornes 25 et E1 permet la commande en fermeture des commutateurs 30 et 31.

En d'autres termes, deux cas peuvent se présenter pour la fermeture du transistor 30. Soit le transistor 31 est fermé et la tension entre les bornes A et E1 est sensiblement nulle. Il en découle que la tension entre les bornes 25 et A est égale à la tension vdc, ce qui permet donc de rendre passant le transistor 30 (cela vaut aussi pour rendre passant le transistor 31 quand le transistor 30 est fermé). Soit le transistor 31 est ouvert et il faut alors que la diode D1 soit polarisée en direct. Il en découle que la tension entre les bornes E1 et A (donc entre E1 et E2) doit être positive, ce qui impose que la tension entre les bornes 25 et E2 est supérieure ou égale à la tension Vdc, donc suffisante pour rendre le transistor 30 passant. Une fois que la grille du transistor 30 est polarisée, on revient (par la fermeture du transistor 30) au cas où la tension entre les bornes E1 et A est nulle.

On notera que, quand le transistor 30 est fermé, le courant dans la diode D1 doit rester suffisant pour sa polarisation en direct. Le cas échéant (en particulier, si le transistor 31 n'est pas fermé), cela peut conduire au blocage de la diode D1 avant le passage par zéro du courant I dans la charge, c'est-à-dire quand le courant I dans la charge devient inférieur au courant de maintien en conduction du transistor 30.

On notera donc que la fermeture du transistor 30, plus généralement, de l'interrupteur unidirectionnel associé aux périodes où le courant I dans la charge est positif (de la borne A vers la borne E2), ne pose plus de problème.

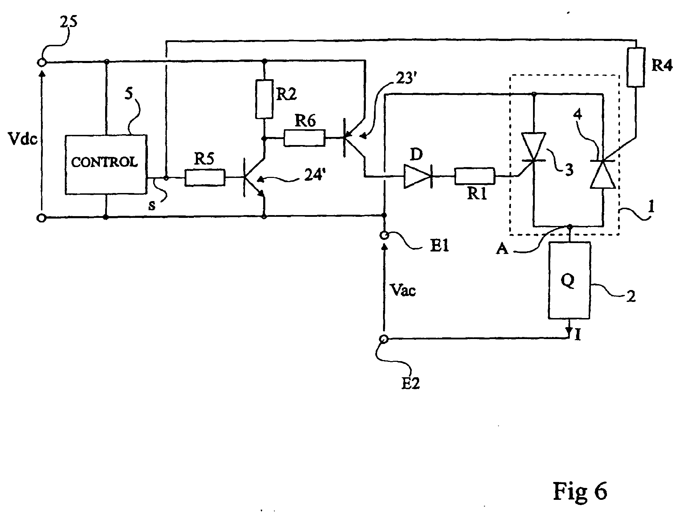

Ainsi, le circuit de la présente invention permet, dans tous les cas, une commande des commutateurs 30 et 31 à partir de tensions de commande positives (pour des transistors) ou, comme dans le mode de réalisation illustré par la suite en relation avec la figure 6, pour des commutateurs commandés en courant, à partir de courants positifs.

Un avantage de la présente invention est qu'une seule source d'alimentation auxiliaire (Vdc) est suffisante pour faire fonctionner l'interrupteur bidirectionnel 1'.

Un autre avantage de la présente invention est qu'elle évite le recours à des composants d'isolement du type optocoupleur ou transformateur.

Un autre avantage de la présente invention est que, grâce à la présence de la diode D et à la référence (E1) choisie pour la tension Vdc, la résistance R1 ne voit qu'une basse tension.

On notera que la présente invention peut être mise en oeuvre dans des applications multiples en adaptant simplement, et de façon classique à la portée de l'homme du métier, la forme devant être donnée aux signaux de commande s1 et s2. Ainsi, si la commande est de type interrupteur statique ou variation de puissance, les commutateurs 30 et 31 sont fermés pour une alternance complète ou par angle de phase. Si le circuit constitue un convertisseur de puissance de type à modulation de largeur d'impulsion (PWM), cela ne pose pas de problèmes de fonctionnement en fréquence, et le fonctionnement est compatible avec le fait que le transistor 30 doit être rendu passant seulement quand la tension Vac est positive. Ainsi, dans le cas où une diode de roue libre est en parallèle avec la charge d'un convertisseur, les périodes de roue libre correspondent aux périodes où la tension entre les bornes A et E2 est nulle.

La figure 6 représente un deuxième mode de réalisation de la présente invention, qui s'applique plus particulièrement au cas où l'interrupteur bidirectionnel 1, en série avec la charge 2, est constitué de deux thyristors 3, 4 montés en antiparallèle. Cela implique qu'il ne soit pas nécessaire d'ouvrir l'interrupteur 1 sous un courant non nul. Dans le mode de réalisation de la figure 6, on a également illustré une variante de réalisation de la partie commande, en utilisant des transistors bipolaires à la place des transistors MOS.

Par rapport au circuit de la figure 5, la diode Zener Dz et la résistance R3 de décharge de la grille du transistor 30 ne sont plus nécessaires. La résistance R1 sert de résistance de polarisation du thyristor 3. une résistance R4 doit être insérée entre la gâchette du thyristor 4 et la sortie s du bloc 5 de commande. Dans l'exemple de la figure 6, on a supposé que le signal s sert à commander simultanément les thyristors 3 et 4 (cas, par exemple, d'une variation de puissance par angle de phase). On notera qu'une telle commande, par un même signal, des commutateurs unidirectionnels était impossible dans les circuits de l'art antérieur.

Côté commande basse tension, le transistor 24 de la figure 5 est remplacé par un transistor bipolaire NPN 24'. Le transistor MOS 23 est remplacé par un transistor bipolaire PNP 23' . Des résistances R5 et R6 sont ajoutées, respectivement, entre la borne de sortie du bloc 5 et la base du transistor 24' , et entre le collecteur du transistor 24' et la base du transistor 23' , pour permettre la commande en courant nécessaire au fonctionnement des transistors bipolaires.

A cette distinction près de la commande en courant, le fonctionnement d'un montage tel qu'illustré par la figure 6 est similaire à celui exposé en relation avec la figure 5.

On notera que différentes combinaisons des schémas des figures 5 et 6 peuvent être réalisées. Par exemple, on peut prévoir une commande au moyen d'un transistor MOS 24 et d'un transistor bipolaire 23'. De plus, le choix entre un interrupteur bidirectionnel 1 ou 1' est indépendant du choix du bloc de commande au moyen de transistors bipolaires ou de transistors MOS.

Cependant, un avantage du mode de réalisation illustré par la figure 5 est que tous ses constituants sont intégrables.

Bien entendu, la présente invention est susceptible de diverses variantes et modifications qui apparaîtront à l'homme de l'art. En particulier, le dimensionnement des différents composants est à la portée de l'homme du métier en fonction de l'application et des indications fonctionnelles données ci-dessus. De plus, on notera que, bien que l'invention ait été exposée ci-dessus en relation avec des modes de réalisation dans lesquels la charge est connectée au neutre de l'alimentation alternative, la transposition du montage de l'invention à une solution dans laquelle une borne de la charge est directement connectée à la phase de l'alimentation alternative et où la référence de la commande est le neutre, est à la portée de l'homne du métier.

En outre, on notera que d'autres types de commutateurs semiconducteurs unidirectionnels peuvent être utilisés pour former un interrupteur bidirectionnel tel que décrit ci-dessus. Par exemple, on pourra utiliser des thyristors ouvrables par la gâchette, des transistors IGBT ou tout autre commutateur unidirectionnel utilisé classiquement pour former, par appariement avec un autre du même type, un interrupteur bidirectionnel quatre quadrants.

## Revendications

1. Circuit de commande d'un interrupteur bidirectionnel (1, 1') connecté en série avec une charge (2) devant être alimentée par une tension alternative (Vac), ledit interrupteur bidirectionnel étant constitué de deux commutateurs unidirectionnels (3, 4 ; 30, 31) associés en antiparallèle, **caractérisé en ce que** lesdits commutateurs sont commandés par un bloc (5) à partir d'une seule basse tension continue (Vdc), et **en ce que** ladite tension continue est référencée sur une première borne (E1) d'application de la tension alternative à laquelle est relié l'interrupteur bidirectionnel.

2. Circuit de commande selon la revendication 1, **caractérisé en ce que** les commutateurs unidirectionnels (30, 31) sont commandés par des signaux (s1, s2) référencés au potentiel de référence de la tension continue (vdc).

3. Circuit de commande selon la revendication 1, **caractérisé en ce que** les commutateurs unidirectionnels (3, 4) sont commandés par un même signal (s) .

4. Circuit de commande selon l'une quelconque des revendications 1 à 3, **caractérisé en ce qu'**il comporte des moyens (D) pour rendre la valeur de ladite tension continue (Vdc) indépendante de la valeur de la tension alternative (Vac) .

5. Circuit de commande selon l'une quelconque des revendications 1 à 4, **caractérisé en ce qu'**il comporte, en série entre une borne (25) positive de l'alimentation continue (Vdc) et une borne de commande d'un premier commutateur unidirectionnel (3, 30), destiné à conduire quand le courant (I) dans la charge (2), connectée entre ladite première borne (E1) et une deuxième borne (E2) d'application de la tension alternative (Vac), est positif, un troisième commutateur (23, 23'), une première résistance (R1) et une première diode (D).

6. Circuit de commande selon la revendication 5, **caractérisé en ce que** le troisième commutateur (23, 23') a une borne de commande connectée au point milieu d'une association en série d'une deuxième résistance (R2) et d'un quatrième commutateur (24, 24'), entre les deux bornes (25, E1) d'application de la basse tension continue (vdc).

7. Circuit de commande selon la revendication 6, **caractérisé en ce que** lesdits troisième et quatrième commutateurs sont des transistors MOS (23, 24).

8. Circuit de commande selon l'une quelconque des revendications 1 à 7, **caractérisé en ce que** lesdits commutateurs unidirectionnels (30, 31) sont des transistors MOS associés, chacun, à une diode (D1, D2) montée en série.

## Claims

1. A circuit for controlling a bidirectional switch (1, 1') series-connected with a load (2) to be supplied by an A.C. voltage (Vac), the bidirectional switch being formed of two one-way switches (3, 4; 30, 31) associated in antiparallel, **characterized in that** said switches are controlled by a block (5) from a single low D.C. voltage (Vdc), and **in that** said D.C. voltage is referenced to a first terminal (E1) of application of the A.C. voltage to which the bidirectional switch is connected.

2. The control circuit of claim 1, **characterized in that** the one-way switches (30, 31) are controlled by signals (s1, s2) referenced to the reference potential of the D.C. voltage (Vdc) .

3. The control circuit of claim 1, **characterized in that** the one-way switches (3, 4) are controlled by a same signal (s) .

4. The control circuit of any of claims 1 to 3, **characterized in that** it includes means (D) for making the value of the D.C. voltage (Vdc) independent from the value of the A.C. voltage (vac) .

5. The control circuit of any of claims 1 to 4, **characterized in that** it includes, in series between a positive terminal (25) of the D.C. power supply (Vdc) and a control terminal of a first one-way switch (3, 30), intended for being on when the current (I) in the load (2), connected between the first terminal (E1) and a second terminal (E2) of application of the A.C. voltage (Vac), is positive, a third switch (23, 23'), a first resistor (R1), and a first diode (D) .

6. The control circuit of claim 5, **characterized in that** the third switch (23, 23') has a control terminal connected to the junction point of a second resistor (R2) and a fourth switch (24, 24'), between the two terminals (25, E1) of application of the low D.C. voltage (Vdc).

7. The control circuit of claim 6, **characterized in that** the third and fourth switches are MOS transistors (23, 24).

8. The control circuit of any of claims 1 to 7, **characterized in that** the one-way switches (30, 31) are MOS transistors associated, each, with a series-connected diode (D1, D2) .

## Patentansprüche

1. Eine Schaltung zum Steuern eines bidirektionalen Schalters (1, 1'), der mit einer Last (2) in Serie geschaltet ist, um eine Wechselstromspannung bzw. A.C. Spannung (Vac) zu liefern, wobei der bidirektionale Schalter aus zwei Einwegeschaltern (3, 4; 30, 31) gebildet ist, die antiparallel assoziiert sind, **dadurch gekennzeichnet**, das die Schalter durch einen Block (5) von einer einzelnen niedrigen Gleichstromspannung , bzw. D..C. Spannung (Vdc) gesteuert werden und dass die D.C. Spannung mit einem ersten Anschluss (E1) an dem die A.C. Spannung anliegt in Bezug gesetzt ist, mit dem der bidirektionale Schalter verbunden ist.

2. Steuerschaltung nach Anspruch 1, **dadurch gekennzeichnet, dass** die Einwegeschalter (30, 31) durch Signale (s1, s2) gesteuert werden, die mit dem Bezugspotential der D.C. Spannung (Vdc) in Beziehung gesetzt werden.

3. Steuerschaltung nach Anspruch 1, **dadurch gekennzeichnet, dass** die Einwegeschalter (3, 4) durch dasselbe Signat (s) gesteuert werden,

4. Steuerschaltung nach einem der Ansprüche 1 bis 3, **dadurch gekennzeichnet, dass** die Schaltung Mittel (D) aufweist, um den Wert der D.C Spannung (Vdc) unabhängig von dem Wert der A.C. Spannung (Vac) zu machen.

5. Steuerschaltung nach einem der Anspruche 1 bis 4, **dadurch gekennzeichnet, dass** sie in Serie zwischen einem positiven Arischluss (25) der D.C. Leistungsquelle (Vdc) und einem Steueranschluss eines ersten Einwegeschalters (3, 30), der eingeschaltet sein soll, wenn der Strom (l) in der Last (2), die zwischen dem ersten Anschluss (E1) und dem zweiten Anschluss (E2) an dem der A.C. Spannung (Vac) anliegt, positiv ist, ein dritter Schalter (23, 23'), ein erster Widerstand (R1) und eine erste Diode (D), vorgesehen sind.

6. Steuerschaltung nach Anspruch 5, **dadurch gekennzeichnet, dass** der dritte Schalter (23, 23') einen Steueranschluss aufweist, der mit dem Verbindungspunkt eines zweiten Widerstands (R2) verbunden ist, und dass ein vierter Schalter (24, 24') zwischen den zwei Anschlüssen (25, E1) an denen eine niedrige D.C. Spannung (Vdc) anliegt, vorgesehen ist.

7. Steuerschaltung nach Anspruch 6, **dadurch gekennzeichnet, dass** die dritten und vierten Schalter MOS-Transistoren (23, 24) sind

8. Steuerschaltung nach einem der Ansprüche 1 bis 7, **dadurch gekennzeichnet, dass** die Einwegeschalter (30, 31) MOS-Transistoren sind, die jeweils mit einer in Serie geschalteten Diode (D1, D2) verbunden sind.
